(19) Europäisches Patentamt
European Patent Office
Office européen des brevets

(11) EP 4 648 066 A1

(12) EUROPEAN PATENT APPLICATION

(43) Date of publication:
12.11.2025 Bulletin 2025/46

(21) Application number: 25165311.9

(22) Date of filing: 21.03.2025

(51) International Patent Classification (IPC):
*H01B 3/20 (2006.01)* *C08K 3/22 (2006.01)*
*B82Y 30/00 (2011.01)*

(52) Cooperative Patent Classification (CPC):
**H01B 3/20;** B82Y 30/00

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 06.05.2024 US 202418656042

(71) Applicant: **GE Vernova Technology GmbH**
**5400 Baden (CH)**

(72) Inventors:
- **YANG, Jingjing**
  **12309-1207 Niskayuna, New York (US)**
- **YIN, Weijun**
  **12309-1207 Niskayuna, New York (US)**
- **BUTTS, Matthew D.**
  **12309-1207 Niskayuna, New York (US)**

(74) Representative: **Rüger Abel Patentanwälte PartGmbB**
**Webergasse 3**
**73728 Esslingen a. N. (DE)**

# (54) HIGHLY STABLE NANO-LIQUID DIELECTRIC INSULATION

(57) Nanoparticle compositions with enhancing dispersibility and long-term stability that can increase thermal conductivity of a dielectric fluid and improving insulation material lifetime, methods of manufacturing the nanoparticle compositions, and dielectric nanofluid compositions with the nanoparticles are provided herein. The nanoparticle compositions may include a metal oxide core and an organofunctional silane shell covering the $TiO_2$ core, wherein the organofunctional silane shell is a structure represented by $R^1$-Si($OR^2$)$_3$.

EP 4 648 066 A1

## Description

TECHNICAL FIELD

This disclosure generally relates to insulation of electrical equipment.

BACKGROUND

Reliability and lifetime of large power and distribution transformers, and other electric equipment using dielectric liquids as insulation, are limited due to insufficient heat dissipation and insulation material degradation. Heat accumulation causes hot spots and thermal degradation of solid insulation materials in electrical equipment and further reduces service lifetime.

SUMMARY

A nanoparticle composition for increasing thermal conductivity in a dielectric fluid, and/or increasing paper lifetime in a dielectric fluid-paper insulation system may include a metal oxide core; and an organofunctional silane shell covering the metal oxide core, wherein the organofunctional silane shell is a structure represented by R1-Si(OR2)3.

A method of producing a nanoparticle composition may include heating an alcoholic solution comprising a soluble titanium precursor, an acid catalyst, a silane precursor, and/or water for a period of time, followed by product separation and purification, wherein the soluble titanium precursor is Ti alkoxide, $TiCl_4$, wherein the acid is organic carboxylic acid or inorganic acid, such as isobutyric acid, acetic acid, and HCl, wherein the silane precursor is a structure represented by $R^1$-$Si(OR^2)_3$.

An optically transparent and stable nanofluid composition comprising nanoparticles, the nanofluid composition including a dielectric liquid; and a titanium dioxide ($TiO_2$) nanoparticles with $TiO_2$ cores covered by an organofunctional silane shell, wherein the organofunctional silane shell is a structure represented by $R^1$-$Si(OR^2)_3$, wherein the nanofluid is optically transparent with nanoparticle concentrations from 0.001wt% to 90wt%.

BRIEF DESCRIPTION OF THE SEVERAL VIEWS OF THE DRAWINGS

To easily identify the discussion of any particular element or act, the most significant digit or digits in a reference number refer to the figure number in which that element is first introduced.

FIG. 1 is an example power transformer in accordance with one embodiment of the present disclosure.
FIG. 2 is a chart showing thermal conductivity improvements of core-shell nanoparticles in dielectric liquids in accordance with one embodiment of the present disclosure.
FIG. 3 is a chart showing density of VG-100® and F425 fluids at different temperatures in accordance with one embodiment of the present disclosure.
FIG. 4 is a chart showing thermal conductivity of VG-100® and F425 fluids at different temperatures in accordance with one embodiment of the present disclosure.
FIG. 5A is a chart showing X-ray data of an amorphous nanoparticle compound for increasing thermal conductivity in a dielectric fluid in accordance with one embodiment of the present disclosure.
FIG. 5B is a chart showing particle size distributions of the amorphous nanoparticle compound of FIG. 5A in accordance with one embodiment of the present disclosure.
FIG. 5C is a chart showing a thermogravimetric analysis (TGA) of the amorphous nanoparticle compound of TiO2 used to prepare 10L 0.9wt% nanofluid. FIG. 5A in accordance with one embodiment of the present disclosure.
FIG. 6A is a chart showing X-ray data of a crystalline nanoparticle compound for increasing thermal conductivity in a dielectric fluid in accordance with one embodiment of the present disclosure.
FIG. 6B is a chart showing intensities of different particle sizes of the crystalline nanoparticle compound of FIG. 6A in accordance with one embodiment of the present disclosure.
FIG. 6C is a chart showing a TGA of the crystalline nanoparticle compound of FIG. 6A in accordance with one embodiment of the present disclosure.

Certain implementations will now be described more fully below with reference to the accompanying drawings, in which various implementations and/or aspects are shown. However, various aspects may be implemented in many different forms and should not be construed as limited to the implementations set forth herein; rather, these implementations are provided so that this disclosure will be thorough and complete, and will fully convey the scope of the disclosure to those skilled in the art. Like numbers in the figures refer to like elements throughout. Hence, if a feature is used across

several drawings, the number used to identify the feature in the drawing where the feature first appeared will be used in later drawings.

DETAILED DESCRIPTION

The reliability and lifetime of large power transformers (LPTs) and distribution transformers (DT), and other electric equipment using dielectric liquids in their insulating systems, are limited due to inadequate heat management and subsequent thermal degradation of the insulating material. For example, insufficient thermal conductivity in the dielectric liquid can cause hot spots, which in turn accelerate the decomposition of solid insulating materials. For example, transformer winding insulation ages faster at higher temperatures, and nanofluid is a type of oil with enhanced thermal and dielectric properties that may improve transformer lifetime. In particular, nanoparticles in the transformer cooling oil may increase thermal conductivity, decreasing hotspot temperature in the transformer windings. Reducing hotspot temperature in transformers increases transformer lifetimes. For example, a transformer lifetime may be estimated using the following equation:

$$Life = e^{(\frac{A}{T_{hst}+273} - B)}$$

, where $T_{hst}$ is the winding hottest spot temperature in Celsius and provides the heat dissipation capability of the transformer coolant oil, and A and B are aging rate slope constants related to the tensile strength retention (e.g., obtained by conducting accelerated aging tests for respective coolant oils).

In some transformers, there are two organic insulation components: oil and paper. Heat, such as heat generated by electric particles in the transformer, may cause the degradation of the insulation components. In addition, water is a catalyst for oil and paper degradation in the insulation. As a result, more water in the transformer oil may cause faster degradation of the insulation components.

TiO2 and Al2O3, for example, have been used as nanoparticles in transformer oil to improve thermal conductivity. However, existing nanoparticles used in oil to improve thermal conductivity become instable over time, so dispersion of the nanoparticles and the long-term stability of the resulting nanofluids is an issue. The present disclosure addresses the dispersion and stability issues to provide nanoparticles with improved dispersibility while improving lifespan of the transformer or other device or equipment using dielectric insulation.

In one or more embodiments, the present disclosure provides (1) new core-shell TiO2 nanoparticle compositions with high dispersibility in dielectric liquids at varying concentrations, (2) methods of making nanoparticle compositions, (3) new transparent dielectric nanofluid compositions comprising these nanoparticles which exhibit improved thermal conductivity, high thermal stability, improved kraft paper tensile strength retention upon aging, and at least comparable dielectric properties (with respect to conventional transformer oils) and (4) methods for making new nanofluid compositions.

The core-shell nanoparticles in the present disclosure include a metal oxide core (e.g., TiO2, Al2O3, ZrO2, Fe2O3, MgO, and the like) covered by an organofunctional silane shell (e.g., prepared via sol-gel synthesis). Unlike other known dielectric materials for insulating electrical equipment, they show high-dispersibility in dielectric liquids at effective concentrations, forming optically transparent nanofluids with excellent thermal and colloidal stability. For instance, no precipitate was observed following aging at 170°C for 730 hours while significant precipitation was observed in nanofluids formulated with known silanized TiO2. In addition, the nanofluids developed in herein exhibit much higher thermal conductivity improvement (e.g., in comparison to a base oil) compared to nanofluid formulated with known silanzied TiO2. For instance, at a concentration of 10 wt% nanoparticles in oil, nanofluids of the present disclosure resulted in a thermal conductivity improvement of 6%, compared to just 3.5% in nanofluid formulated with known silanzied TiO2.

On one level, the present disclosure addresses problems anticipated by the aging of large power transformers (LPTs) and distribution transformers (DT) in the field. Thermal degradation of insulating systems causes failures and shorter LPT lifetime, which could be mitigated if the nanofluids of the present disclosure were implemented. In particular, the present disclosure addresses the long-standing challenge of colloidal and thermal stability nanofluids. Dielectric nanofluids made with the nanoparticles herein show exceptional colloidal and thermal stability, in distinct contrast to nanofluids formulated with known silanized TiO2 nanoparticles, paving their way toward practical applications. In addition to exhibiting improved stability, the new nanofluids improve the thermal conductivity of the dielectric liquid, which should lengthen the effective lifetime of the LPT. The nanofluids of the present disclosure are suitable for use in new LPTs as well as in the retrofit market for LPTs currently in the field.

The problems of insufficient nanofluid dispersibility, stability and thermal conductivity are solved by developing enhanced core-shell silanized $TiO_2$ nanoparticles herein using a sol-gel synthetic method starting from molecular titanium precursors. By manipulating reagent conditions, reaction parameters and silane functionality nanoparticle and nanofluid material compositions that provide the desired high dispersibility, thermal stability in dielectric liquids and thermal conductivity were identified. In addition, the enhanced insulation herein may increase the service life of LPTs from 40 years to over 80 years.

Table 1 below shows example thermal conductivity improvement using various nanofluids.

**Table 1: Thermal Conductivity for Different Nanofluids**

| Temperature (°C) | Thermal Conductivity Improvement Using 2.5 wt% $TiO_2$ Nanofluid | Thermal Conductivity Improvement Using 0.25 wt% late GEN-2 Nanofluid | Thermal Conductivity Improvement Using 0.25 wt% late GEN-3 Nanofluid |
|---|---|---|---|
| 25 | +3.9% | +4.1% | +2.1% |
| 40 | +3.6% | -0.7% | +2.0% |
| 60 | +3.0% | -1.1% | +2.0% |
| 80 | +1.2% | -1.2% | +2.6% |
| 100 | +1.4% | -0.8% | +2.9% |

Table 2 below shows properties of various LPT insulation materials.

**Table 2: Properties of Transformer Insulation Materials**

| Properties | SOA Mineral Oil | VG-100® | 0.9 wt% GEN-2 Nanofluid | 0.15 wt% GEN-3 Nanofluid |
|---|---|---|---|---|
| Breakdown voltages (KVrms 1 mm gap) | >20 | 45.49 (2.36) | 45.13 (0.63) | 46.79 (2.17) |
| Density g/cm$^3$ (15°C) | 0.910 | 0.923 | 0.926 | 0.925 |
| Flammability | Combustible | Non-Flammable | Non-Flammable | Non-Flammable |
| Flashpoint (°C) | >145 | 328 | 322 | - |
| Pour Point (°C) | <-40 | -10 | -18 | - |
| Thermal Conductivity at 25 °C (W/m.k) | 0.11414 | 0.16282 | 0.17062 | 0.16618 |

Table 3 below shows tensile strength improvement of paper samples after the aging process in VG-100® systems.

**Table 3: Tensile Strength Improvement of Paper Samples After Aging Process in VG-100® Systems**

| VG-100® | | | | | | | |
|---|---|---|---|---|---|---|---|
| | | 170 °C | | 180 °C | | 190 °C | |
| Pure VG-100 | VG1 | 408 Hours | 1008 Hours | X | X | X | X |
| | VG2 | X | X | 216 Hours | 504 Hours | X | X |
| | VG3 | X | X | X | X | 120 Hours | 264 Hours |
| VG-100+0.15 wt% F425 Nanofluid | VG-100+NF 1 | +9.2% | +14.9% | X | X | X | X |
| | VG-100+NF2 | X | X | +13.2% | +10.5% | X | X |
| | VG-100+NF3 | X | X | X | X | +35.9% | +25.8% |

Table 4 below shows tensile strength improvement of paper samples after the aging process in mineral oil systems.

**Table 4: Tensile Strength Improvement of Paper Samples After Aging Process in Mineral Oil Systems**

| Mineral Oil (MO) | | | | | | | |
|---|---|---|---|---|---|---|---|
| | | 160 °C | | 170 °C | | 180 °C | |
| Pure MO | MO1 | 408 Hours | 1008 Hours | X | X | X | X |
| | MO2 | X | X | 216 Hours | 504 Hours | X | X |
| | MO3 | X | X | X | X | 120 Hours | 264 Hours |
| MO+0.15 wt% F445 Nanofluid | MO1+NF1 | +1.9% | +6.2% | X | X | X | X |
| | MO2+NF2 | X | X | +0.8% | +11.0% | X | X |
| | MO3+NF3 | X | X | X | X | +5.8% | +13.1% |

Sol-gel chemistry for core-shell nanoparticles with high dispersibility includes a nanoparticle synthesis and nanoparticle formulation. Commercialized silanized $TiO_2$ nanofluid, gen-1 nanofluid, early gen-2 nanofluid, late gen-2 nanofluid, other gen-2 nanofluids, early gen-3 nanofluids, and late gen-3 nanofluids have been developed.

In one or more embodiments, the silanized core-shell $TiO_2$ used in the enhanced dielectric insulation materials herein may be produced based on the following formula:

$$\mathrm{Ti(OR)_4} + \text{acid} + \mathrm{H_2O} + \text{sec-butanol} + \text{silane} \xrightarrow{heat} \text{Silanized core-shell } \mathrm{TiO_2}.$$

By varying the reaction conditions, a series of nanoparticles with different properties may be achieved, such as amorphous/crystalline, different particle sizes, and different organize content.

Tables 5 and 6 below show example Silane structure variations to the chemical equation above to produce enhanced dielectric insulation materials.

**Table 5: Example Silane Structures and Their Properties (in VG-100®)**

| Silane Structures $R^1$-Si($OR^2$)$_3$, where $R^2$ = ethyl, methyl, etc. | Dispersibility in Dielectric Liquid VG-100® |
|---|---|
| $R^1$=Glycidoxypropyl | Not dispersible |
| $R^1$=Acetoxypropyl | Not dispersible |
| $R^1$=Aminopropyl | Not dispersible |
| $R^1$=Methoxytriethyleneoxypropyl | Not dispersible |
| $R^1$=Hexyl | Clear |
| $R^1$=Octyl | Clear |
| $R^1$=Octadecyl | Clear |
| $R^1$=Isooctyl | Clear |
| $R^1$=Ethylphenethyl | Clear |
| $R^1$=Propyl | Clear |
| $R^1$=Butyl | Clear |

**Table 6: Example Silane Structures and Their Properties (in Mineral Oil)**

| Silane Structures $R^1$-Si($OR^2$)$_3$, where $R^2$ = ethyl, methyl, etc. | Dispersibility in Dielectric Liquid Mineral Oil |
|---|---|
| $R^1$=Octyl | Clear |
| $R^1$=Isooctyl | Clear |

The enhanced dielectric insulation materials herein may be used not only in LPTs and other transformers, but also in other electrical equipment using liquid insulation, electric vehicles, energy storage batteries, data centers, electric ships, and aviation, in which high-performance dielectric cooling fluids are used.

In addition to the enhanced dielectric insulation materials herein, additional techniques to improve the lifetime of equipment using dielectric cooling fluids may include a more robust paper insulation, formulating cooling fluid with water scavengers, and/or other techniques for reducing water concentration.

The above descriptions are for purposes of illustration and are not meant to be limiting. Numerous other examples, configurations, processes, etc., may exist, some of which are described in greater detail below. Example embodiments will now be described with reference to the accompanying figures.

FIG. 1 is an example power transformer 100 in accordance with one embodiment of the present disclosure.

Referring to FIG. 1, the power transformer 100 may include a core 102, low voltage coils 104 around the core 102, and high voltage coils 106 around the low voltage coils 104. The core 102, the low voltage coils 104, and the high voltage coils 106 may be immersed in a dielectric cooling fluid 108.

FIG. 2 is a chart 200 showing thermal conductivity improvements of core-shell nanoparticles in dielectric liquids in accordance with one embodiment of the present disclosure.

Referring to FIG. 2, the chart 200 shows enhanced nanoparticles in mineral oil (MO) and in VG-100® compared to earlier generation (early GEN) nanoparticles. As shown, the enhanced core-shell nanoparticles herein improve thermal conductivity relative to previous nanoparticles, in both MO and VG-100®.

FIG. 3 is a chart 300 showing density of VG-100® and F425 fluids at different temperatures in accordance with one embodiment of the present disclosure.

Referring to FIG. 3, the chart 300 shows the density of VG-100® and F425 fluids at different temperatures. Table 2 above shows improved densities using nanofluids in comparison to VG-100® and MO, for example.

FIG. 4 is a chart 400 showing conductivity improvements of VG-100® and F425 fluids at different temperatures in accordance with one embodiment of the present disclosure.

Referring to FIG. 4, the chart 400 shows the conductivity of VG-100® and F425 fluids at different temperatures. Table 2 above shows improved conductivity using nanofluids in comparison to VG-100® and MO, for example.

FIGs. 2-4 show that adding nanoparticles to dielectric fluids changes thermal properties of the fluids. For example, thermal conductivity and density are improved with the introduction of nanoparticles. The enhanced nanoparticle structures herein further improve the thermal properties of the fluids and address dispersion of the nanoparticles over time.

FIG. 5A is a chart 500 showing X-ray data of an amorphous nanoparticle compound for increasing thermal conductivity in a dielectric fluid in accordance with one embodiment of the present disclosure.

In particular, the sample whose X-ray data are shown in FIG. 5A is a silanized core-shell $TiO_2$ compound. The X-ray data shown in the chart 500 indicate that the enhanced compound is amorphous.

FIG. 5B is a chart 550 showing intensities of different particle sizes of the amorphous nanoparticle compound of FIG. 5A in accordance with one embodiment of the present disclosure.

Referring to FIG. 5B, the chart 550 shows particle size distributions of 10L 0.9wt% Amorphous TiO2 VG-100.

FIG. 5C is a chart 570 showing a thermogravimetric analysis (TGA) of the amorphous nanoparticle compound of TiO2 used to prepare 10L 0.9wt% nanofluid. FIG. 5A in accordance with one embodiment of the present disclosure.

Referring to FIG. 5C, the TGA data show that about 51 wt% of the core-shell nanoparticle is organic (e.g., from the silane shell).

FIG. 6A is a chart 600 showing X-ray data of a crystalline nanoparticle compound for increasing thermal conductivity in a dielectric fluid in accordance with one embodiment of the present disclosure.

In particular, the sample whose X-ray data are shown in FIG. 6A is a silanized core-shell $TiO_2$ compound. The X-ray data shown in the chart 600 indicate that the enhanced compound is crystalline.

FIG. 6B is a chart 650 showing intensities of different particle sizes of the crystalline nanoparticle compound of FIG. 6A in accordance with one embodiment of the present disclosure.

Referring to FIG. 6B, the chart 650 shows particles of F180-2wt% in VG 100® [Steady State.

FIG. 6C is a chart 670 showing a TGA of the crystalline nanoparticle compound of FIG. 6A in accordance with one embodiment of the present disclosure.

Referring to FIG. 6C, the TGA data show that about 23 wt% of the core-shell nanoparticle is organic (e.g., from the silane shell).

Referring to FIGs. 5A-6C, by varying the reaction conditions, a series of nanoparticles with different properties can be achieved (e.g., as shown in Tables 5 and 6 above). The enhanced nanoparticles herein may be amorphous/crystalline, of different particle sizes, and may have different organic content.

It is understood that the above descriptions are for purposes of illustration and are not meant to be limiting.

As used herein, unless otherwise specified, the use of the ordinal adjectives "first," "second," "third," etc., to describe a common object, merely indicates that different instances of like objects are being referred to and are not intended to imply that the objects so described must be in a given sequence, either temporally, spatially, in ranking, or in any other manner.

Although specific embodiments of the disclosure have been described, one of ordinary skill in the art will recognize that numerous other modifications and alternative embodiments are within the scope of the disclosure. For

example, any of the functionality and/or processing capabilities described with respect to a particular device or component may be performed by any other device or component. Further, while various illustrative implementations and architectures have been described in accordance with embodiments of the disclosure, one of ordinary skill in the art will appreciate that numerous other modifications to the illustrative implementations and architectures described herein are also within the scope of this disclosure.

Although embodiments have been described in language specific to structural features and/or methodological acts, it is to be understood that the disclosure is not necessarily limited to the specific features or acts described. Rather, the specific features and acts are disclosed as illustrative forms of implementing the embodiments. Conditional language, such as, among others, "can," "could," "might," or "may," unless specifically stated otherwise, or otherwise understood within the context as used, is generally intended to convey that certain embodiments could include, while other embodiments do not include, certain features, elements, and/or steps. Thus, such conditional language is not generally intended to imply that features, elements, and/or steps are in any way required for one or more embodiments or that one or more embodiments necessarily include logic for deciding, with or without user input or prompting, whether these features, elements, and/or steps are included or are to be performed in any particular embodiment.

## Claims

**1.** A nanoparticle composition for increasing thermal conductivity in a dielectric fluid, and/or increasing paper lifetime in a dielectric fluid-paper insulation system, the nanoparticle composition comprising:

a metal oxide core; and
an organofunctional silane shell covering the metal oxide core,
wherein the organofunctional silane shell is a structure represented by $R^1\text{-}Si(OR^2)_3$.

**2.** The nanoparticle composition of claim 1, wherein the nanoparticle is highly dispersed in dielectric fluid to form optically transparent liquids at variable concentrations, from 0.001wt%-40wt%.

**3.** The nanoparticle composition of claim 1, wherein the metal oxide is $TiO_2$, or Ti containing metal oxides.

**4.** The nanoparticle composition of claim 1, wherein the $R^1$ is alkyl or substituted alkyl groups.

**5.** The nanoparticle composition of claim 1, wherein the $R^1$ is Glycidoxypropyl, Acetoxypropyl, Aminopropyl, Methoxytriethyleneoxypropyl, Hexyl, Octyl, Octadecyl, Isooctyl, Ethylphenethyl, Propyl, or Butyl.

**6.** The nanoparticle composition of claim 1, wherein the $R^2$ is ethyl or methyl.

**7.** The nanoparticle composition of claim 1, wherein nanoparticle composition is associated with a large power transformer.

**8.** The nanoparticle composition of claim 1, wherein nanoparticle composition is associated with a distribution transformer.

**9.** A method of producing a nanoparticle composition, the method comprising:

heating an alcoholic solution comprising a soluble titanium precursor, an acid catalyst, a silane precursor, and/or water for a period of time, followed by product separation and purification,
wherein the soluble titanium precursor is Ti alkoxide, $TiCl_4$,
wherein the acid is organic carboxylic acid, comprising at least one of isobutyric acid, acetic acid, or an inorganic acid comprising HCl,
wherein the silane precursor is a structure represented by $R^1\text{-}Si(OR^2)_3$.

**10.** The method of claim 9, wherein the $R^1$ is alkyl or substituted alkyl groups, comprising Glycidoxypropyl, Acetoxypropyl, Aminopropyl, methoxytriethyleneoxypropyl, Hexyl, Octyl, Octadecyl, isooctyl, ethylphenethyl, Propyl, or Butyl.

**11.** The method of claim 9, wherein the $R^2$ is ethyl or methyl.

**12.** The method of claim 9, wherein the nanoparticle is highly dispersed in dielectric fluid to form optically transparent

liquids at variable concentrations, from 0.001 wt%-40wt%.

**13.** The method of claim 9, wherein the $R^1$ is alkyl or substituted alkyl groups.

**14.** The method of claim 9, wherein nanoparticle composition is associated with a large power transformer.

**15.** The method of claim 9, wherein nanoparticle composition is associated with a distribution transformer.

**16.** An optically transparent and stable nanofluid composition comprising nanoparticles, the nanofluid composition comprising:

a dielectric liquid; and
a titanium dioxide ($TiO_2$) nanoparticles with $TiO_2$ cores covered by an organofunctional silane shell,
wherein the organofunctional silane shell is a structure represented by $R^1$-$Si(OR^2)_3$, wherein the nanofluid is optically transparent with nanoparticle concentrations from 0.001wt% to 90wt%, from 0.001wt%-40wt%.

**17.** The nanofluid composition of claim 16, wherein the $R^1$ is alkyl or substituted alkyl groups comprising Glycidoxypropyl, Acetoxypropyl, Aminopropyl, methoxytriethyleneoxypropyl, Hexyl, Octyl, Octadecyl, Isooctyl, Ethylphenethyl, Propyl, or Butyl.

**18.** The nanofluid composition of claim 16, wherein the $R^2$ is ethyl or methyl.

**19.** The nanofluid composition of claim 16, wherein the nanoparticles are formed by mixing silanized core-shell titanium dioxide ($TiO_2$) in the dielectric liquid, using heat.

**20.** The nanofluid composition of claim 16, wherein nanofluid composition is associated with a large power transformer or a distribution transformer.

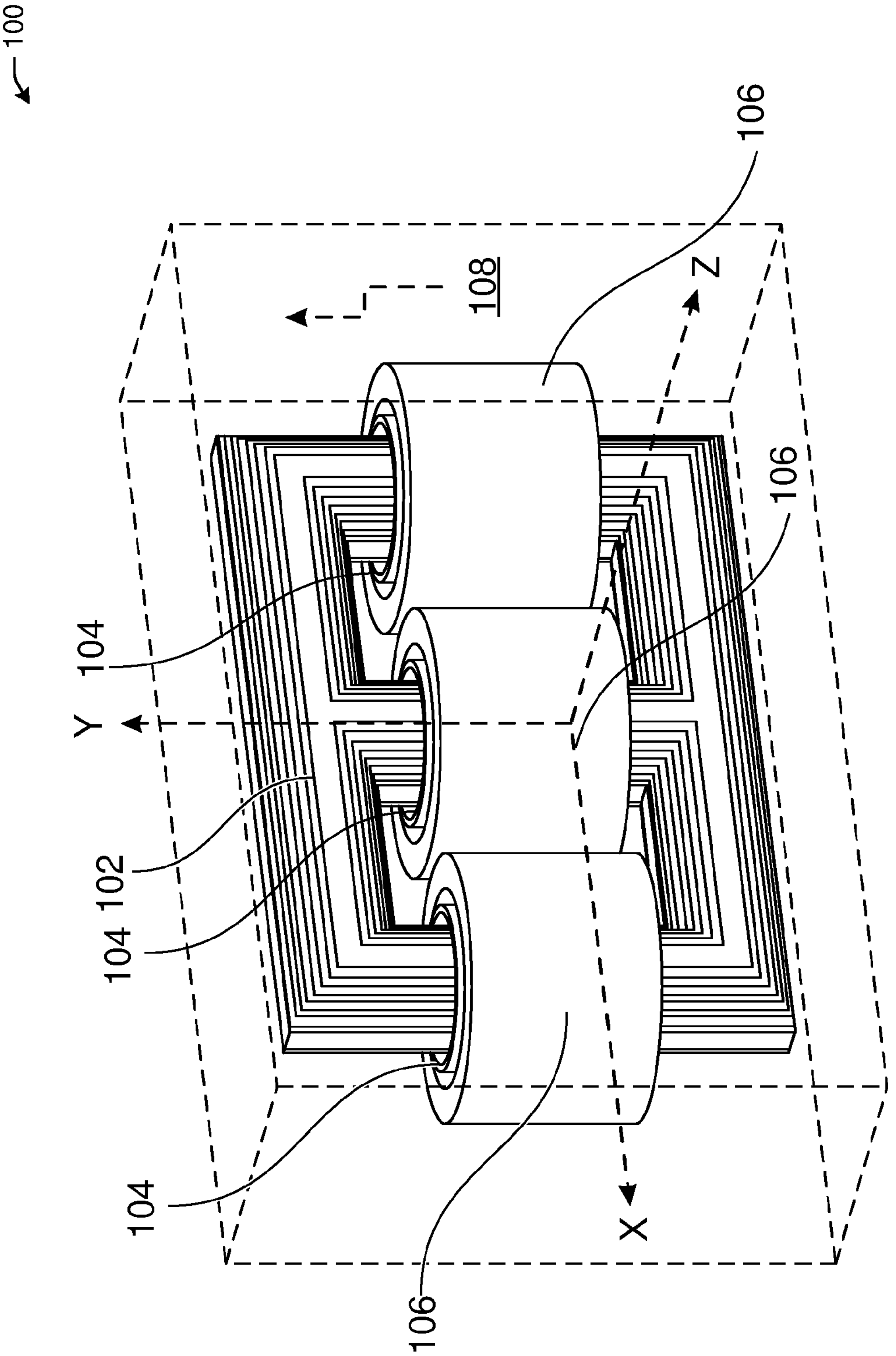


FIG. 1

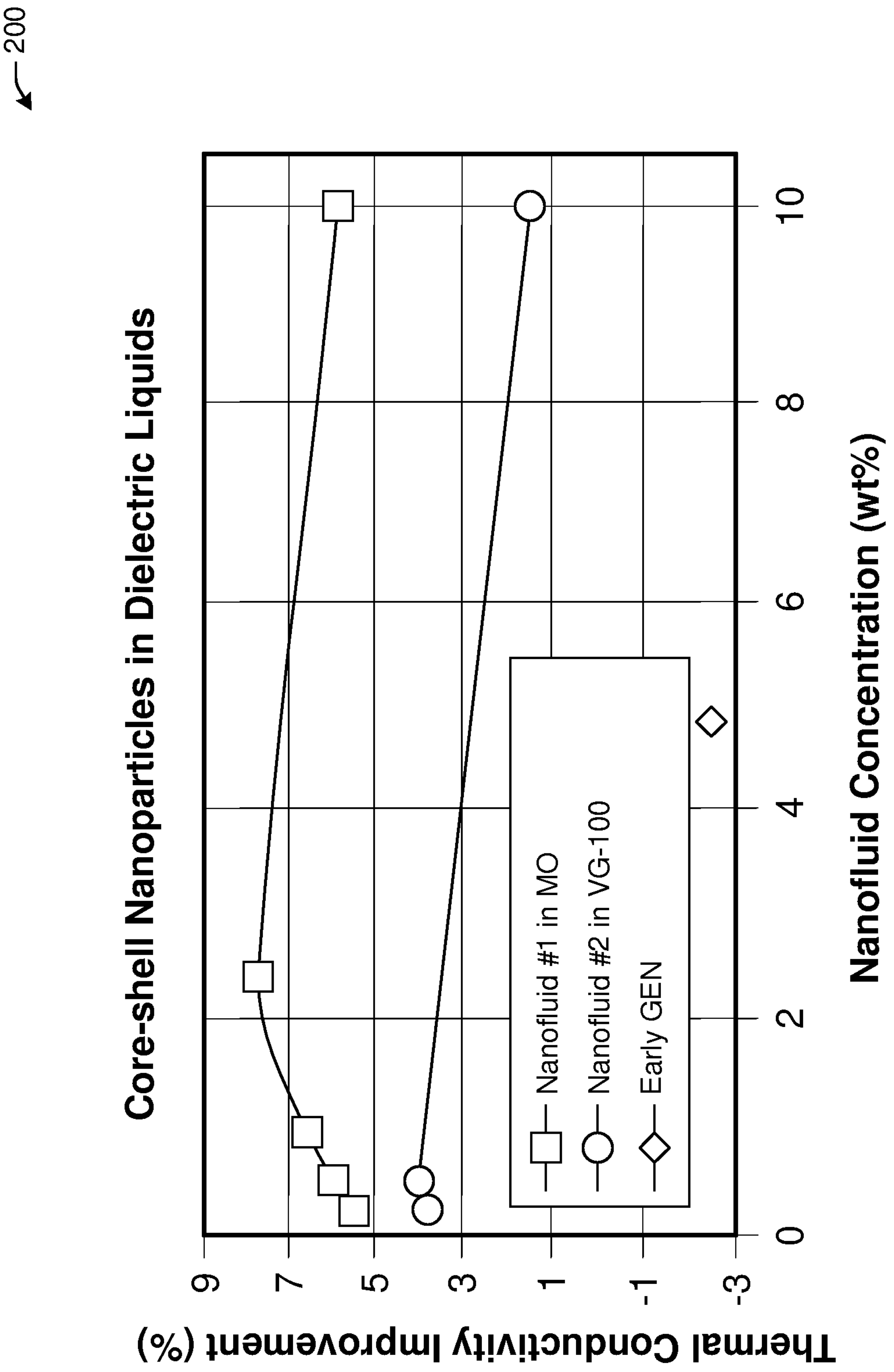
200
Core-shell Nanoparticles in Dielectric Liquids
Thermal Conductivity Improvement (%)
9
7
5
3
1
-1
-3
0
2
4
6
8
10
Nanofluid Concentration (wt%)
Nanofluid #1 in MO
Nanofluid #2 in VG-100
Early GEN

FIG. 2

300

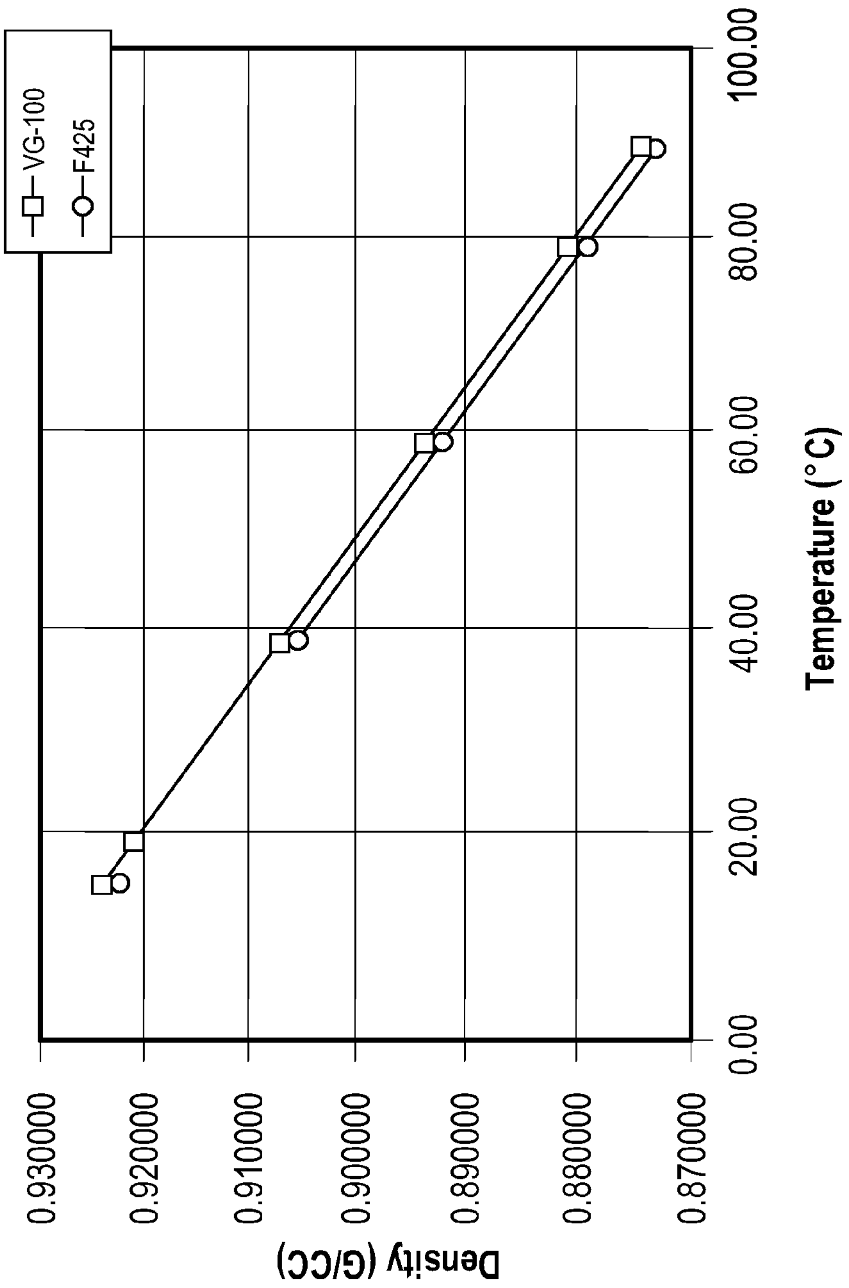

VG-100
F425
Density (G/CC)
0.930000
0.920000
0.910000
0.900000
0.890000
0.880000
0.870000
0.00
20.00
40.00
60.00
80.00
100.00
Temperature (°C)


FIG. 3

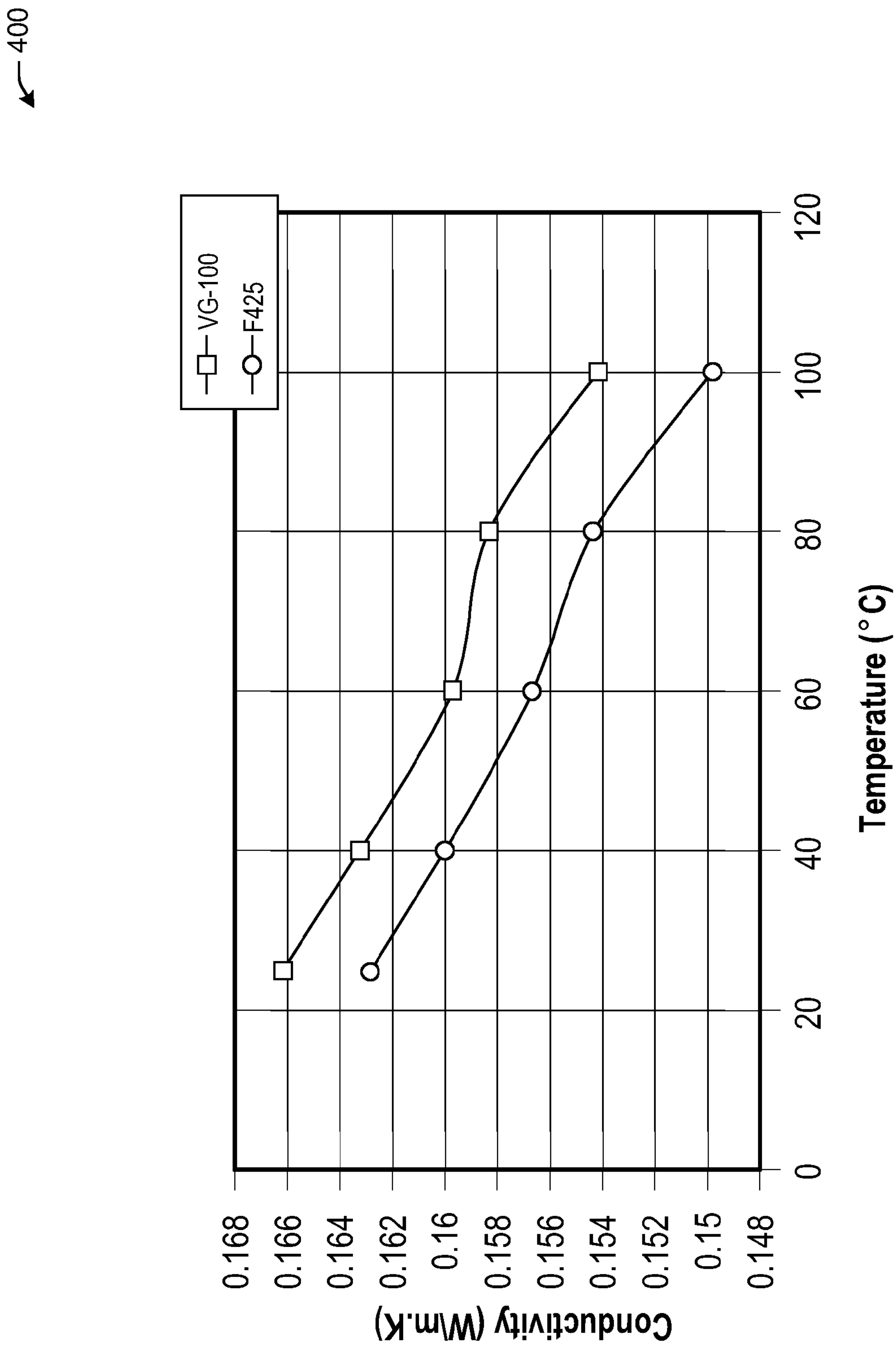
400
VG-100
F425
Conductivity (W\m.K)
0.168
0.166
0.164
0.162
0.16
0.158
0.156
0.154
0.152
0.15
0.148
0
20
40
60
80
100
120
Temperature (°C)

FIG. 4

500

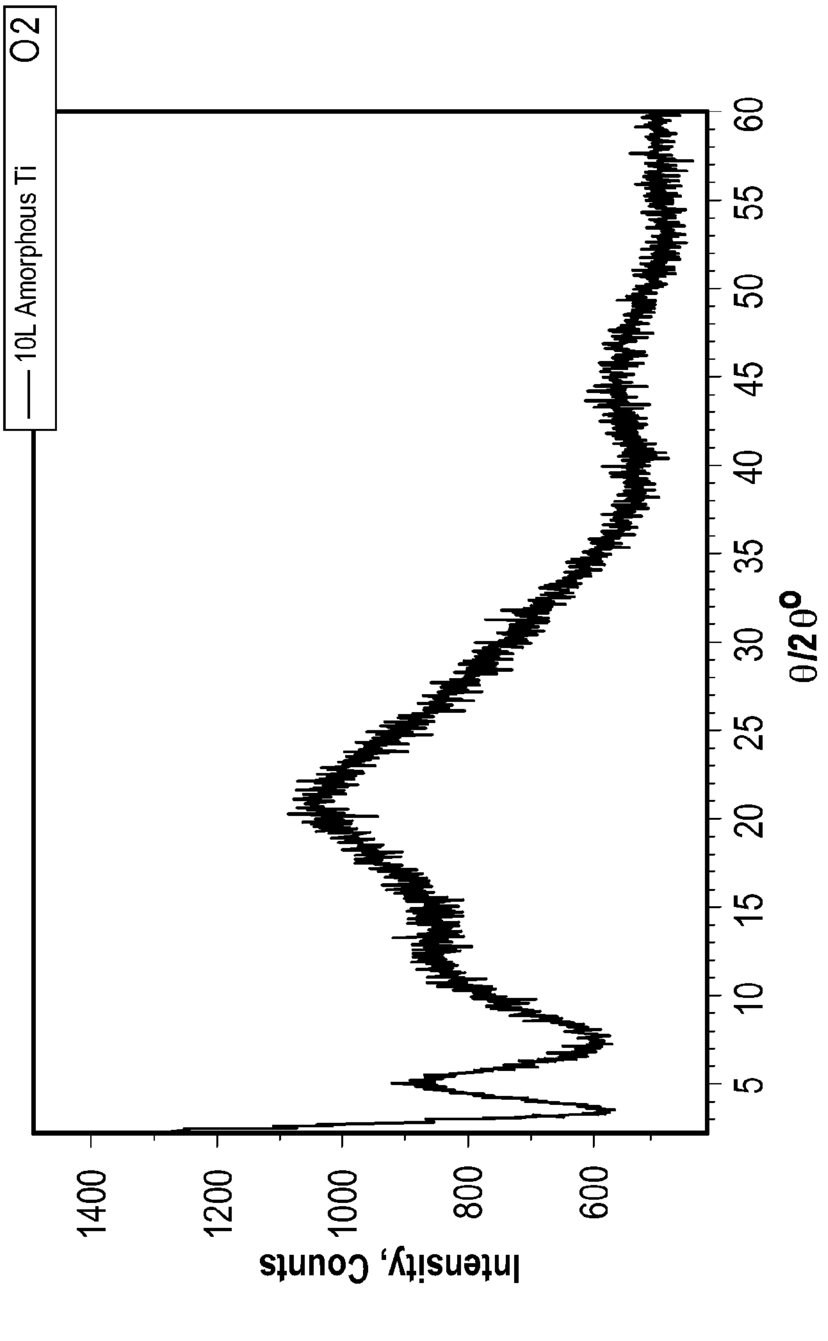

10L Amorphous Ti
O2
Intensity, Counts
θ/2θ°
1400
1200
1000
800
600
5
10
15
20
25
30
35
40
45
50
55
60


FIG. 5A

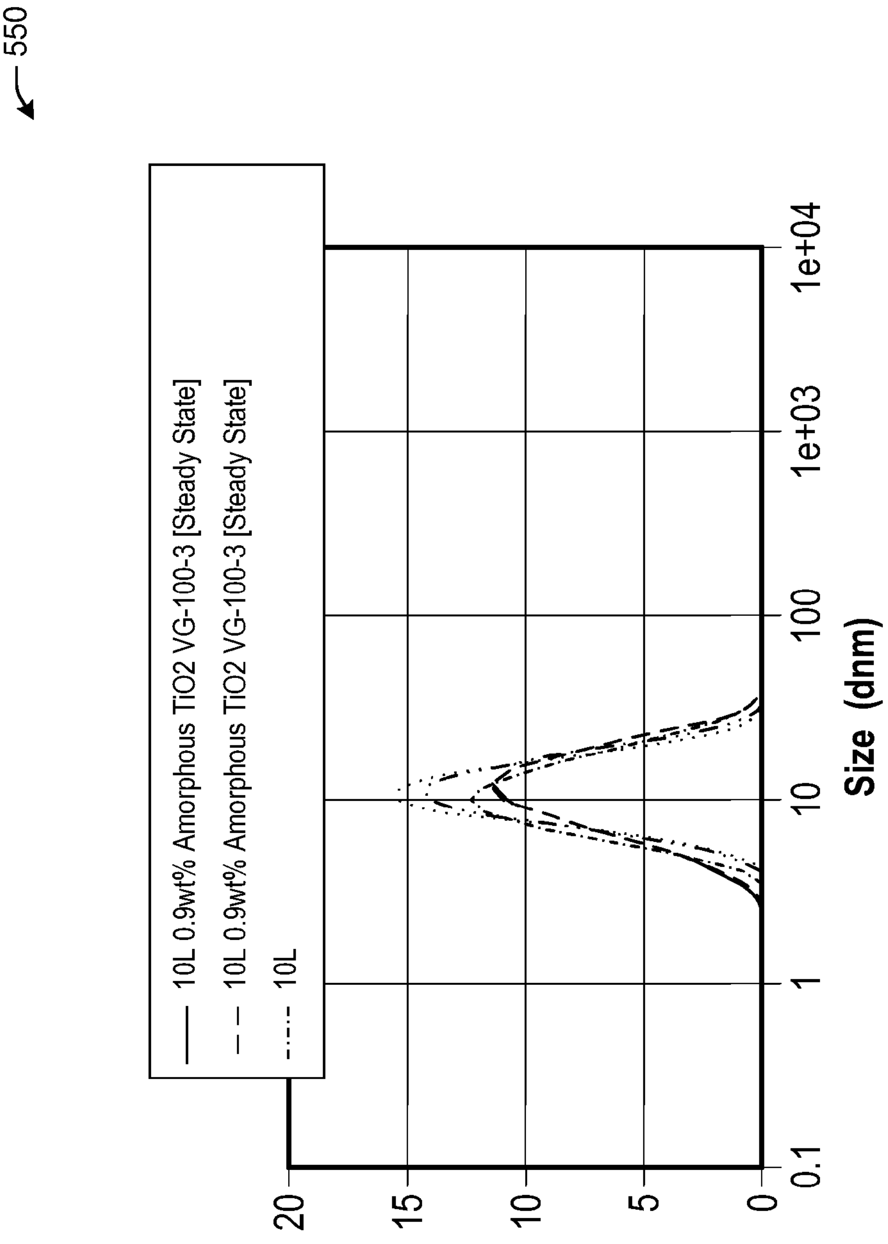
550
10L 0.9wt% Amorphous TiO2 VG-100-3 [Steady State]
10L 0.9wt% Amorphous TiO2 VG-100-3 [Steady State]
10L
20
15
10
5
0
0.1
1
10
100
1e+03
1e+04
Size (dnm)

FIG. 5B

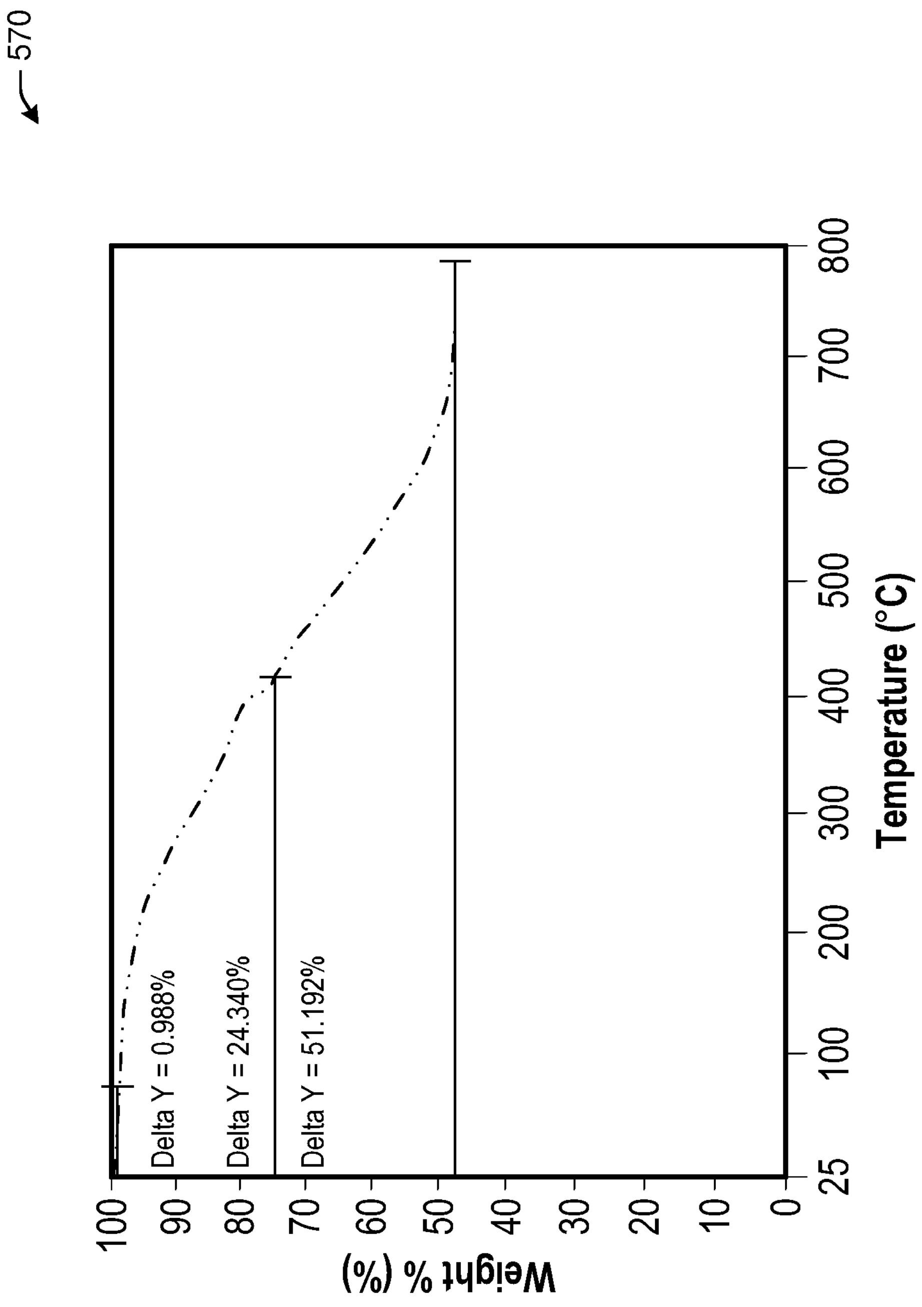
570
Delta Y = 0.988%
Delta Y = 24.340%
Delta Y = 51.192%
Weight % (%)
100
90
80
70
60
50
40
30
20
10
0
25
100
200
300
400
500
600
700
800
Temperature (°C)

FIG. 5C

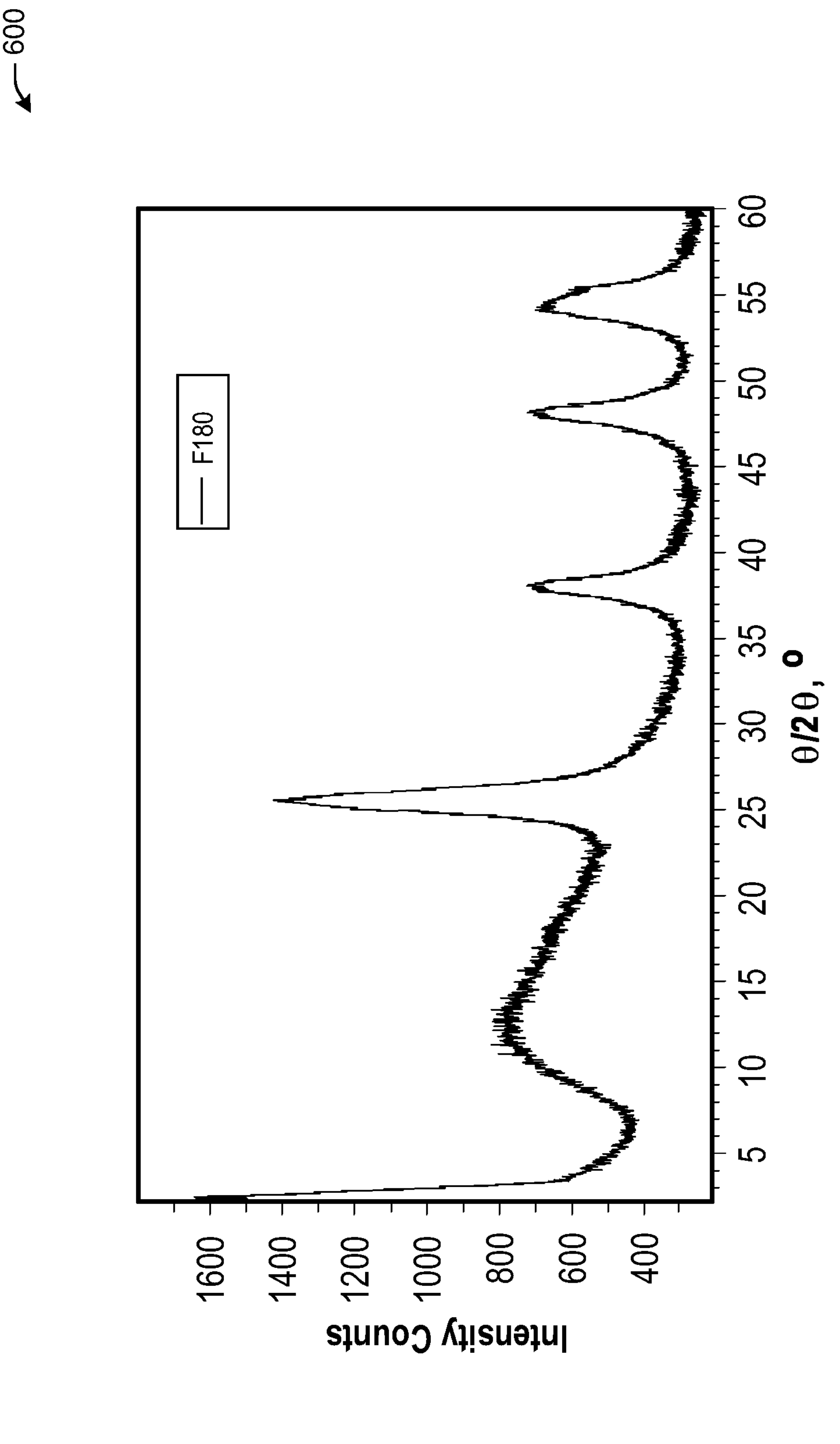
600
F180
Intensity Counts
1600
1400
1200
1000
800
600
400
5
10
15
20
25
30
35
40
45
50
55
60
θ/2θ, °

FIG. 6A

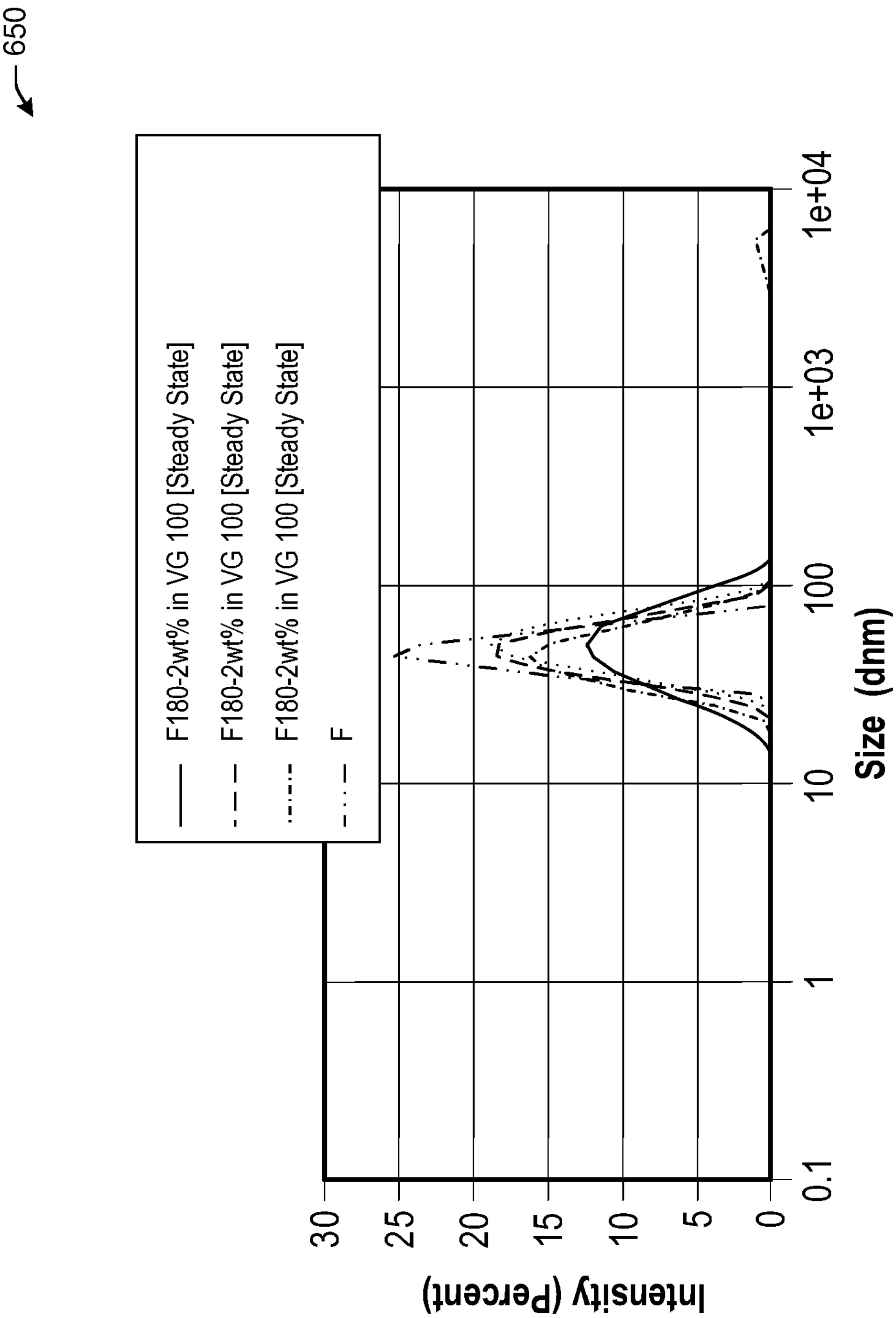
650
F180-2wt% in VG 100 [Steady State]
F180-2wt% in VG 100 [Steady State]
F180-2wt% in VG 100 [Steady State]
F
Intensity (Percent)
30
25
20
15
10
5
0
0.1
1
10
100
1e+03
1e+04
Size (dnm)

FIG. 6B

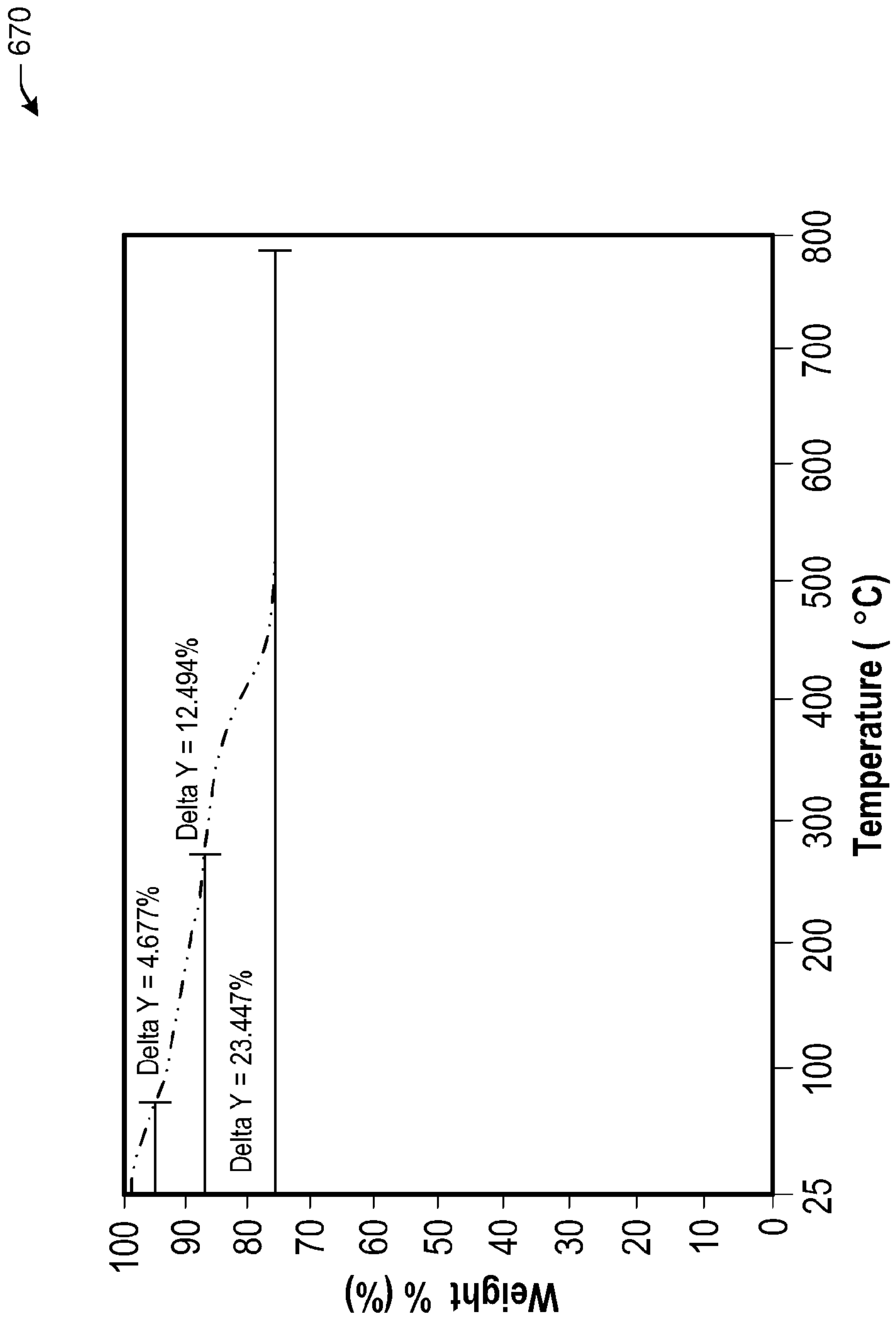
670
Delta Y = 4.677%
Delta Y = 12.494%
Delta Y = 23.447%
Weight % (%)
100
90
80
70
60
50
40
30
20
10
0
25
100
200
300
400
500
600
700
800
Temperature ( °C)

FIG. 6C

Europäisches Patentamt
European Patent Office
Office européen des brevets

# EUROPEAN SEARCH REPORT

Application Number
EP 25 16 5311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/285781 A1 (YIN WEIJUN [US]) 31 October 2013 (2013-10-31)<br>* paragraph [0033] - paragraph [0034]; claims 1-16; tables 1-2 *<br>* paragraph [0026] - paragraph [0026] *<br>----- | 1-20 | INV.<br>H01B3/20<br>C08K3/22<br><br>ADD.<br>B82Y30/00 |
| A | MANSOUR DIAA-ELDIN A ET AL: "The Effect of Surface Modification of Titania Nanoparticles on the Dielectric Properties of Nanofluids",<br>2019 21ST INTERNATIONAL MIDDLE EAST POWER SYSTEMS CONFERENCE (MEPCON), IEEE,<br>17 December 2019 (2019-12-17), pages 1199-1203, XP033725581,<br>DOI: 10.1109/MEPCON47431.2019.9007971<br>[retrieved on 2020-02-24]<br>* the whole document *<br>----- | 1-20 | |
| A | US 2023/041380 A1 (LIFSCHITZ ARRIBIO ALEJO [US] ET AL) 9 February 2023 (2023-02-09)<br>* the whole document *<br>----- | 1-20 | TECHNICAL FIELDS SEARCHED (IPC) |
| A | LONGYU LI ET AL: "Synthesis of titania/polymer core-shell hybrid microspheres",<br>COLLOID AND POLYMER SCIENCE, SPRINGER, BERLIN, DE,<br>vol. 288, no. 2,<br>5 January 2010 (2010-01-05), pages 199-206, XP019780621,<br>ISSN: 1435-1536, DOI: 10.1007/S00396-009-2172-3<br>* the whole document *<br>----- | 1-20 | H01B<br>C08K<br>B82Y |

The present search report has been drawn up for all claims

1

| Place of search | Date of completion of the search | Examiner |
|---|---|---|
| Munich | 1 September 2025 | Marsitzky, Dirk |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 25 16 5311

This annex lists the patent family members relating to the patent documents cited in the above-mentioned European search report. The members are as contained in the European Patent Office EDP file on
The European Patent Office is in no way liable for these particulars which are merely given for the purpose of information.

01-09-2025

| Patent document cited in search report | Publication date | Patent family member(s) | Publication date |
|---|---|---|---|
| US 2013285781 A1 | 31-10-2013 | NONE | |
| US 2023041380 A1 | 09-02-2023 | NONE | |

EPO FORM P0459

For more details about this annex : see Official Journal of the European Patent Office, No. 12/82